# EUROPEAN PATENT SPECIFICATION

(11) **EP 0 403 936 B1**
(45) Date of publication and mention of the grant of the patent: **17.04.1996**
(21) Application number: 90111107.0
(22) Date of filing: 12.06.1990
(51) Int. Cl.: H01L 31/18, H01L 21/321, C23C 14/08, C23C 14/58

(54) **Method for producing a conductive oxide pattern**
Verfahren zur Herstellung einer Struktur aus leitfähigem Oxyd
Procédé pour la fabrication d'une gravure d'oxyde conducteur

(30) Priority: 15.06.1989 JP 152911/89
(43) Date of publication of application: 27.12.1990
(73) Proprietor: SEL SEMICONDUCTOR ENERGY LABORATORY CO., LTD., Atsugi-shi Kanagawa-ken 243 (JP)
(72) Inventor: Fukui, Takashi, Atsugi-shi, Kanagawa-ken, 243 (JP); Sakamoto, Naoya, Atsugi-shi, Kanagawa-ken, 243 (JP); Fukada, Takeshi, Ebina-shi, Kanagawa-ken, 243,04 (JP)
(74) Representative: Grünecker, Kinkeldey, Stockmair & Schwanhäusser Anwaltssozietät

(56) References cited:
- EP-A- 0 293 645
- EP-A- 0 311 690
- THIN SOLID FILMS. vol. 15, no. 2, March 1989, LAUSANNE CH pages 151 - 162; M.Venkatesan et al.: "Indium tin oxide thin films for metallization in microelectronic devices"
- PATENT ABSTRACTS OF JAPAN vol. 12, no. 193 (E-617) 04 June 1988, & JP-A-62 295422 (FUJITSU) 22 December 1987,
- JOURNAL OF VACUUM SCIENCE AND TECHNOLOGY: PART A. vol. 5, no. 4, July 1987, NEW YORK US pages 1952 - 1955; S.Yamamoto et al.: "Properties of Sn-doped In2O3 by reactive magnetron sputtering and subsequent annealing"
- PATENT ABSTRACTS OF JAPAN vol. 11, no. 288 (E-542) 17 September 1987, & JP-A-62 086878 (NEC) 21 April 1987,

## Description

### METHOD FOR PRODUCING A CONDUCTIVE OXIDE PATTERN

### BACKGROUND OF THE INVENTION

### Field of the Invention

The present invention relates to a method for producing a conductive oxide pattern according to the preamble of claim 1 which can be used in a liquid crystal display or an image sensor or the like.

### Description of the Prior Art

In recent years, a large-size liquid crystal display and image sensor having a substrate and a conductive oxide pattern on the substrate have become more common. Hand in hand with this trend, the substrate having the conductive oxide pattern have also increased in size. This has led to a high degree of technological innovation in the fabrication of this type of large-area substrate with good efficiency and at low cost.

In a conventional technology for a manufacture of the substrate having the conductive oxide pattern, for example in the case of ITO(indium tin oxide) film, the ITO film is formed on an insulating substrate by commonly known vaporization or sputtering methods. At this time. the substrate is heated to 250 to 400°C and oxygen is introduced to lower the resistivity and increase the translucent characteristics of the ITO. As the area of the ITO is increased, a further decrease in the resistivity value is required and the temperature at which the ITO film is formed is generally increased. Following this formation of the ITO film, a resist is formed in the specific pattern on the ITO film, using commonly known photolithography technology. Next, etching is performed, using the resist as a mask. For wet etching, etchants such as hydrochloric acid + ferric chloride, hot hydrochloric acid + ferric chloride, are used where zinc powder can be used in place of the ferric chloride. The ITO film is etched by the etchants to render a portion of the ITO film under the resist remain and the substrate having the remaining portion of the ITO film is used in liquid crystal displays, image sensors, and solar cells, and the like. Dry etching is not frequently used because no activated type of etchant has been found which provides a conductive oxide pattern of ITO or the like with good etching efficiency. Also, because the etching rate is low, the dry etching is not suitable and not practically used for processing a large area substrate of liquid crystal displays, solar cells, and the like.

The following problem areas are inherent in these methods. The tact time of the manufacturing process of the ITO film is long. Specifically, after the substrate is set in a vacuum device to form the ITO film, the substrate is heated to a predetermined temperature so a waiting period is necessary. If the temperature of the substrate is suddenly lowered to room temperature after the film has been formed, the formed ITO film tends to peel from the substrate. Therefore the temperature must be reduced gradually. As a result, one batch of ITO film takes a relatively long time to produce. Because the process requires heating in a vacuum, it is difficult to obtain a uniform temperature distribution, therefore it is necessary that a heating device is provided more extensively than the ITO film is formed on the substrate. This increases the size of a reaction chamber. In addition, the reproducibility is poor because of the heating process. An ITO film which is formed with the substrate heated in this manner is extremely dense and has an extremely low electrical resistance. Accordingly, a powerful etchant is required to etch this ITO film in a predetermined pattern. In addition it is necessary to heat the etchant during the etching process in order to increase the etching rate.

When the ITO film is etched with a powerful etchant of this type, the edge of the etching pattern loses its sharpness and the pattern undulates. Also, a large volume of hydrogen is produced which causes the etching pattern mask to peel away or sustain damage during etching. It is therefore extremely difficult to obtain a fine etching pattern on a large-area substrate.

From EP-A-0293645 the method for producing a patterned, transparent and conductive indium tin oxide layer on a basis of amorphous silicon is known comprising the steps of forming the indium tin oxide layer, etching said oxide layer and subsequently tempering the arrangement in oxygen atmosphere or air at a temperature of lower than 250°C. From the scientific publication by M. Venkatesan et al., in Thin Solid Films, Volume 15, No. 2 (1989), Page 151 to 162, it is known to pattern indium tin oxide films by using an etchant comprising a mixture of HCl and HNO₃.

### SUMMARY OF THE INVENTION

An object of the present invention is to provide, with due consideration to the drawbacks of such conventional methods, a method for producing a conductive oxide pattern which has a low resistivity and is easily produced.

The foregoing object is solved according to the present invention with the method according to claim 1,

### BRIEF DESCRIPTION OF THE DRAWINGS

These and other objects, features, and advantages of the present invention will become more apparent from the following description of the preferred embodiments taken in conjunction with the accompanying drawings, in which:
FIG. 1 is an outline of the film-forming process of the present invention.
FIGs. 2(A) to 2(D) are graph to show a comparison of the characteristics of an ITO film formed by the method of the present invention and an ITO film formed by a conventional method, respectively.
FIGs. 3(A) to 3(C), and FIG. 4 are a partial cross sectional view to show an embodiment of the present invention, respectively.

### DETAILED DESCRIPTION OF THE PREFERRED EMBODIMENTS

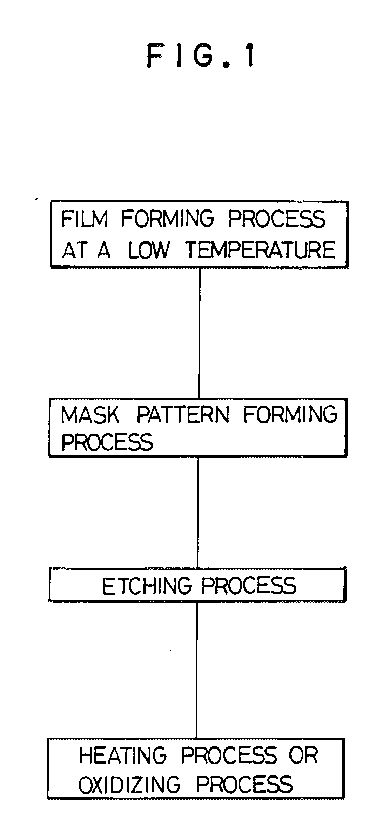

FIG. 1 shows an outline of the film-forming process according to the prior art. Following the process order shown in FIG. 1, a conductive oxide film is formed on an insulating substrate by a commonly known vaporizing or sputtering method. At this time, the film is formed without heating or at a low temperature not more than 100°C. This allows a great reduction in the waiting period required in the vaporization or sputtering method. During the formation of the film a quantity of oxygen is introduced into the reaction chamber to give the same partial pressure as required for other commonly known conventional methods.

The conductive oxide film obtained by this method is not a complete oxide film, but rather placed in an intermediate state (half-oxide) since the conductive oxide film is formed at the low temperature. The resistivity is higher than by the other conventional method, being 1 x 10⁻³ Ω·cm or greater. It takes much less time to form a conductive oxide pattern than in the other conventional method because the conductive oxide film is formed at a lower temperature than in the other conventional method. A large device is not required and reproducibility is vastly improved. In the vapor deposition method, electrical energy may be imparted to the introduced oxygen vapor to create a plasma for reactive vaporing.

In the case where the film is formed by the sputtering method in which a target is sputtered, the distance between the sputtered target and the substrate must be suitably changed because the substrate is heated by radiant heat generated in the sputtered target.

When the film is formed by the CVD method at normal pressure, a temperature of 100 to 300°C is necessary to cause the raw material vapor to undergo a decomposition reaction. In this case, some means is required to heat the raw material vapor so that the substrate itself is heated as little as possible.

Next. in using commonly known photolithography technology a resist pattern is formed from masking material on the conductive oxide film, followed by wet etching using the resist as a mask. Because the conductive oxide film is in the intermediate state(half-oxidel, the conductive oxide film has an etching speed ten times as fast as the conventional conductive oxide film. Therefore an HCl etchant even at room temperature etches the conductive oxide film. Because the etchant has a weak etching capability and the etching rate is high, an edge of a pattern after the etching is extremely fine.

Next, the patterned conductive oxide film is placed for 10 to 180 min. in a high temperature oven maintained at 100 to 400 °C. An atmosphere within this oven is preferably an oxygen atmosphere or an air atmosphere. In place of the oxygen or the air atmosphere the patterned conductive oxide film may be placed in a high temperature oven of a nitrogen atmosphere containing oxygen 5-10% under a reduced pressure. After the conductive oxide film in the Intermediate state(half-oxide) is oxidized, it has a resistivity in the 1.0 X 10⁻⁴ Ω·cm to 3.5 X 10⁻⁴ Ω·cm range.

Use of the above described method makes possible the formation of an ITO(indium tin oxide) film with low resistivity and good reproducibility and a weak etchant can be used in the etching process.

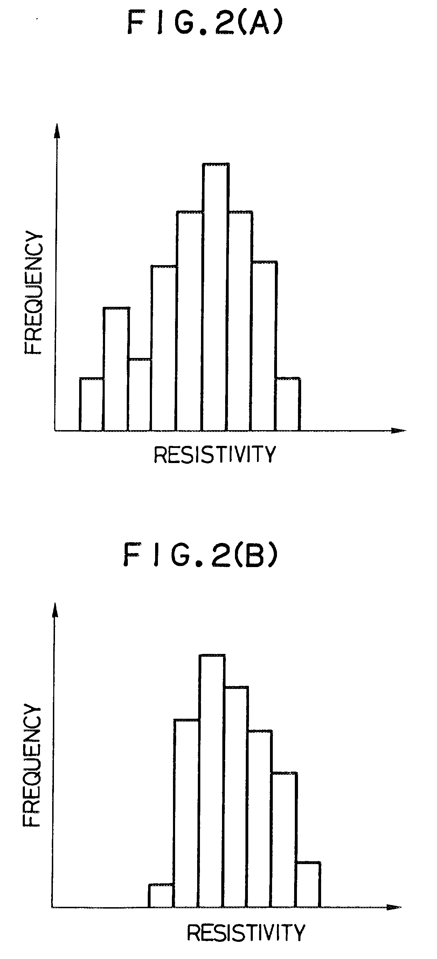

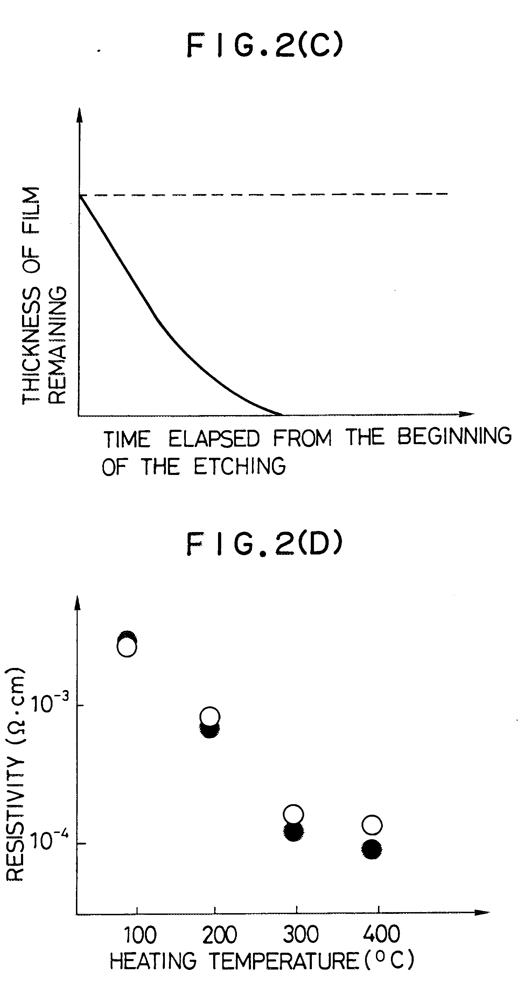

The characteristics of an ITO film formed by the above method and an ITO film formed by another conventional method are compared in FIG. 2. FIG. 2(a) and FIG. 2(b) are histograms showing reproducibility. The axis of abscissa is resistivity and the axis of ordinate is frequency, that is the count corresponding to the number of samples. FIG. 2(a) gives the results for the conventional method and FIG. Z(b) the method described above FIG. 2(c) shows the etching velocity. The axis of ordinate gives the thickness of film remaining when the conductive oxide film is etched by HCl at 25°C, while the axis of abscissa gives the time elapsed from the beginning of the etching. The solid line applies to the film as of the above described method, the dotted line to another conventional film. The film as of the above described method is clearly superior. FIG. 2(d) shows heating temperatures in °C along the axis of abscissa versus resistivities in Ω·cm along the axis of ordinate. The solid dots represent the film of the conventional method while the open dots indicate the film of the above described method. Except for a slightly lower resistivity in the conventional film, there is very little difference between the two.

As described above, the ITO film of the above described method shows an improved reproducibility and the almost same resistivity as the conventional film and the ITO film can easily be etched.

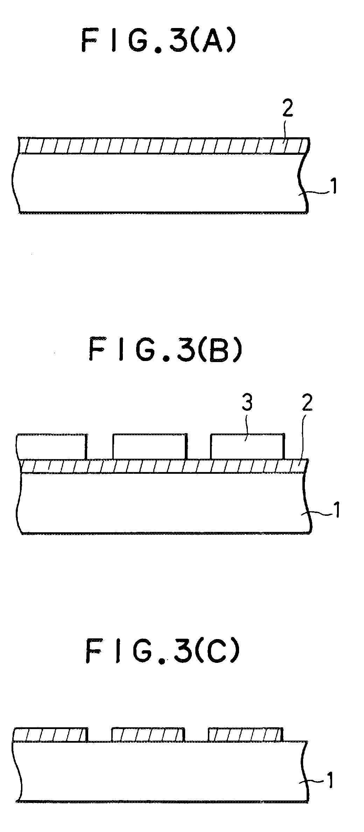

Now referring to FIG. 3, an embodiment of the above method will be described. First, a 1500 Å (10Å=1nm) half-oxide ITO film 2 was formed on a translucent, insulating substrate 1 using a commonly known DC magnetron sputtering process. The film forming conditions are given in the following table 1.

**Table 1**

| | |
|---|---|
| ITO target | SnO₂ 10 wt% incl. |
| Back pressure | 133.10⁻⁶ Pa (1 X 10⁻⁶ Torr) |
| O₂ partial pressure | 0.04 Pa (3 X10⁻⁴ Torr) |
| Sputtering pressure | 1.33 Pa (1 X 10⁻ Torr) |
| Current | 1.5 mA/cm |
| Voltage | 450 V |
| Substrate temperature | 27 °C |

The interval between the substrate and the target was 150 mm. An ITO film with a resistivity of 1.2 X 10⁻³ Ω·cm was obtained.

Next, using conventional photolithography technology, a resist 3 was patterned to an L/S (line and space) = 350/40 (micro meters). The substrate was then submerged in 6 normality HCl at 23°C for two minutes, and an etching of the ITO film with a thickness of 1500Å was completed in 1 minute and 30 seconds. The etching rate was 1500Å/1.5min., i.e., 1000Å/min. The resist was removed by using a conventional exfoliation liquid to give the condition illustrated in FIG. 3(c). The substrate was then heated in a clean oven (in an atmosphere of air) at 200°C for 60 minutes to obtain a sheet resistance of 14 Ω/cm. In this way a fabrication of a liquid crystal display substrate of the size of an A-4 sheet (640 dots X 400 dots) was completed.

After the completion, the resistivity of the ITO film was measured as 1.6 X 10⁻⁴ Ω·cm.

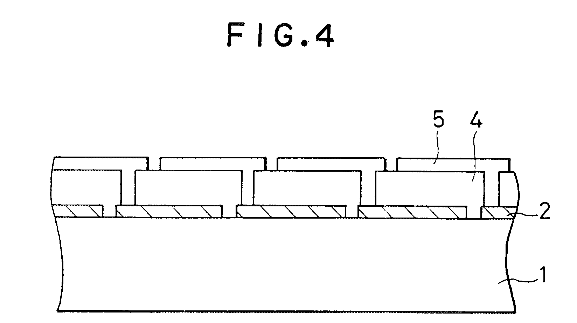

FIG. 4 shows an embodiment of the present invention. A 1200 Å (10Å=1nm) half-oxide film 2 of tin oxide was formed on a soda glass substrate 1 using a commonly known electron beam(EB) vaporization device. The film forming conditions are given in the following table 2.

**Table 2**

| | |
|---|---|
| Vaporization Source | SnO₂ pellet |
| Back pressure | 1 X 10⁻⁶ Torr |
| Oxygen partial pressure | 3 X 10⁻⁴ Torr |
| EB acceleration voltage | 10 KV |
| Mission current | 100 mA |
| Substrate temperature | 50 °C |

Under these conditions, a tin oxide film with a resistivity of 4.2 X 10⁻³ Ω·cm was obtained.

Next, using conventionai photolithography technology, the tin oxide film was patterned. At this time, an etching of the tin oxide film with a thickness of 1200Å was completed in 20 seconds at 23 °C.

Following this, a plasma ashing process was performed on the substrate under an atmosphere of oxygen to remove the photoresist. Subsequently, in the same device used for the plasma ashing process, the tin oxide, which was in the form of an incompletely oxidized conductive film, was oxidized by a heat treatment for oxygen piasma treatment. Because this oxidizing heat treatment was assisted by plasma energy, the time required for the treatment was only about 2/3 that required under a normal oxidizing vapor atmosphere. It was therefore possible to reduce the resistivity value of the conductive layer to less than 2.5 X 10⁻⁴ Ω·cm.

Also, performing the heat treatment of the substrate simultaneously with the ashing process had the effect of further shortening the treatment time.

Next, an a-Si film 4 comprising P-, I-, and N-layers of 100 Å. 7000 Å, and 300 Å respectively was formed using a commonly known plasma CVD process. The a-Si layer was patterned using commonly known photolithography technology, and an electrode 5 was formed on the rear side surface to provide a 12-series amorphous silicon solar cell as illustrated in FIG. 4.

By utilizing the method of the present invention, a conductive oxide film with low resistivity can be easily produced at low cost. In addition, an improvement in the sharpness of the pattern edge after the etching process is also obtained. As a result, a low cost conductive oxide film pattern can be formed on a large-area substrate with good reproducibility.

## Claims

1. A method for producing a conductive oxide pattern comprising the steps of:
forming a conductive oxide layer on a substrate, wherein said substrate is at a temperature not higher than 100°C during said forming step;
patterning said conductive oxide layer including forming a mask pattern on said conductive oxide layer, etching a portion of said conductive oxide layer with an etchant in order to leave a portion of said conduc-ive oxide layer under said mask pattern remaining and removing said mask pattern; and
further oxidizing the patterned conductive oxide layer,
**characterized in that**
said etchant consists essentially of hydrochloric acid ;
an insulating substrate is used;
and in that said removing step comprises removing said mask pattern by plasma ashing with said substrate heated;
and wherein said removing step and said oxidizing step are sequentially performed in a common reaction container with an oxygen containing plasma.

2. The method for producing a conductive oxide pattern in claim 1 wherein said oxidizing step is performed at a temperature in the range of 100 to 400°C.

3. The method for producing a conductive oxide pattern in claim 1 wherein said mask pattern is a photoresist pattern.

4. The method for producing a conductive oxide pattern in claim 3 wherein said oxidizing step is performed at a temperature in the range of 100 to 400°C.

5. The method for producing a conductive oxide pattern in claim 3 wherein the concentration of said hydrochloric acid is not more than 6 normality.

6. The method for producing a conductive oxide pattern in claim 1 wherein said conductive oxide pattern is made of indium tin oxide.

7. The method for producing a conductive oxide pattern in claim 1 wherein said conductive oxide pattern is made of tin oxide.

8. The method for producing a conductive oxide pattern in claim 1 wherein said removing step is performed in an oxidizing atmosphere.

## Patentansprüche

1. Ein Verfahren zum Herstellen eines leitfähigen Oxidmusters mit den folgenden Schritten:
Bilden einer leitfähigen Oxidschicht auf einem Substrat, wobei das Substrat sich bei einer Temperatur von nicht höher als 100°C während dieses Bildungsschritts befindet;
Musterstrukturierung der leitfähigen Oxidschicht einschließlich Bildung eines Maskenmusters auf der leitfähigen Oxidschicht, Ätzen eines Teils der leitfähigen Oxidschicht mit einem Ätzmittel, um einen Teil der leitfähigen Oxidschicht unter dem Maskenmuster zu belassen, und Entfernen des Maskenmusters; und
weiteres Oxidieren der mit einem Muster strukturierten leitfähigen Oxidschicht,
**dadurch gekennzeichnet**, daß
das Ätzmittel im wesentlichen aus Chlorwasserstoffsäure besteht;
ein isolierendes Substrat verwendet wird;
und daß der Schritt des Entfernens ein Entfernen des Maskenmusters durch Plasmaveraschung bei erwärmtem Substrat umfaßt;
und wobei der Schritt des Entfernens und der Schritt des Oxidierens sequentiell in einem herkömmlichen Reaktionsbehälter mit einem Sauerstoff enthaltenden Plasma ausgeführt werden.

2. Verfahren zum Herstellen eines leitfähigen Oxidmusters nach Anspruch 1, wobei der Schritt des Oxidierens bei einer Temperatur in dem Bereich von 100 bis 400°C ausgeführt wird.

3. Verfahren zum Herstellen eines leitfähigen Oxidmusters nach Anspruch 1, wobei das Maskenmuster ein Photoresistmuster ist.

4. Verfahren zum Herstellen eines leitfähigen Oxidmusters nach Anspruch 3, wobei der Schritt des Oxidierens bei einer Temperatur im Bereich von 100 bis 400°C ausgeführt wird.

5. Verfahren zum Herstellen eines leitfähigen Oxidmusters nach Anspruch 3, wobei die Konzentration der Chlorwasserstoffsäure nicht mehr als 6 Normalität beträgt.

6. Verfahren zum Herstellen eines leitfähigen Oxidmusters nach Anspruch 1, wobei das leitfähige Oxidmuster aus Indium-Zinn-Oxid hergestellt wird.

7. Verfahren zum Herstellen eines leitfähigen Oxidmusters nach Anspruch 1, wobei das leitfähige Oxidmuster aus Zinnoxid hergestellt wird.

8. Verfahren zum Herstellen eines leitfähigen Oxidmusters nach Anspruch 1, wobei der Schritt des Entfernens in einer oxidierenden Atmosphäre ausgeführt wird.

## Revendications

1. Procédé pour la production d'une gravure d'oxyde conducteur, comprenant les étapes consistant à:
former une couche d'oxyde conducteur sur un substrat, dans lequel ledit substrat est à une température non supérieure à 100°C pendant ladite étape de formation,
modeler de ladite couche d'oxyde conducteur, comprenant la formation d'un dessin de masque sur ladite couche d'oxyde conducteur, la corrosion d'une partie de ladite couche d'oxyde conducteur à l'aide d'un décapant, afin de laisser une partie de ladite couche d'oxyde conducteur sous ledit dessin de masque restant et l'élimination dudit dessin de masque, et
oxyder davantage la couche d'oxyde conducteur modelée,
caractérisé en ce
que ledit décapant se compose essentiellement d'acide chlorhydrique,
qu'il est utilisé un substrat isolant,
et en ce que ladite étape d'élimination comprend l'élimination dudit dessin de masque par calcination au plasma avec ledit substrat chauffé, sont
et dans lequel ladite étape d'élimination et ladite étape d'oxydation sont réalisées en séquence, dans un récipient de réaction commun, à l'aide d'un plasma contenant de l'oxygène.

2. Procédé pour la production d'une gravure d'oxyde conducteur suivant la revendication 1, dans lequel ladite étape d'oxydation est réalisée à une température de l'ordre de 100 à 400°C.

3. Procédé pour la production d'une gravure d'oxyde conducteur suivant la revendication 1, dans lequel ledit dessin de masque est un dessin de photo-résiste.

4. Procédé pour la production d'une gravure d'oxyde conducteur suivant la revendication 3, dans lequel ladite étape d'oxydation est réalisée à une température de l'ordre de 100 à 400°C.

5. Procédé pour la production d'une gravure d'oxyde conducteur suivant la revendication 3, dans lequel la concentration dudit acide chlorhydrique n'est pas supérieure à normalité 6.

6. Procédé pour la production d'une gravure d'oxyde conducteur suivant la revendication 1, dans lequel ladite gravure d'oxyde conducteur est en oxyde mixte d'indium et d'étain.

7. Procédé pour la production d'une gravure d'oxyde conducteur suivant la revendication 1, dans lequel ladite gravure d'oxyde conducteur est en oxyde d'étain.

8. Procédé pour la production d'une gravure d'oxyde conducteur suivant la revendication 1, dans lequel ladite étape d'élimination est réalisée dans une atmosphère oxydante.
